# EUROPEAN PATENT APPLICATION

(11) **EP 4 535 948 A1**
(43) Date of publication of application: **09.04.2025**
(21) Application number: 24199616.4
(22) Date of filing: 10.09.2024
(51) Int. Cl.: H05K 7/20

(54) **COOLING ASSEMBLY FOR HIGH POWER DENSITY COMPUTER RACKS**

(30) Priority: 19.09.2023 US 202363539262 P; 03.09.2024 US 202418823364
(71) Applicant: Vertiv Corporation, Westerville, OH 43082 (US)
(72) Inventor: MERKAS, Antonio, Westerville, OH, 43082 (US); NAMLIC, Denis, Westerville, OH, 43082 (US); RANCIC, Denis, Westerville, OH, 43082 (US)
(74) Representative: Bryn-Jacobsen, Caelia

(57) **Abstract**

A cooling system for rack system cooling is disclosed. The cooling system includes a rack system, a plurality of heat exchangers, and a liquid distribution sub-system. The plurality of heat exchangers are vertically arranged beneath the rack system, where a primary heat exchanger is disposed adjacent to a front portion of the rack system, and a secondary heat exchanger is disposed adjacent to a rear portion of the rack system. The liquid distribution sub-system includes: one or more supply pipes disposed between the primary and secondary heat exchangers, which delivers a cooling fluid to the plurality of heat exchangers, where the cooling fluid is warmed by the plurality of heat exchangers; one or more return pipes collecting the warmed cooling fluid from the plurality of heat exchangers; and a manifold coupled to the one or more supply pipes and the one or more return pipes, where the manifold is configured to distribute the cooling fluid throughout the rack system.

## Description

### CROSS-REFERENCE TO RELATED APPLICATION

The present application claims the benefit under 35 U.S.C. § 119(e) of United States Provisional Patent Application No. 63/539,262.

### TECHNICAL FIELD

The present disclosure generally relates to cooling systems for electronic equipment, and more particularly, to a cooling system capable of managing the temperature of high power density computer racks.

### BACKGROUND

The rapid evolution of high-performance computing technologies, encompassing fields such as artificial intelligence (Al) and machine learning (ML), has ushered in an era where computer racks exhibit extreme power density levels. These advanced systems can generate substantial heat, creating a need for robust and innovative cooling solutions to maintain optimal performance and prevent thermal-related issues. In response to these challenges, cooling assemblies have become pivotal components within data centers, tasked with a formidable mission of dissipating heat efficiently and reliably. The evolving landscape of cooling technologies for high power density computer racks reflects ongoing efforts to strike an intricate balance between performance, energy efficiency, and spatial considerations, driving the continuous development of cutting-edge cooling solutions.

Therefore, there exists a need for improved cooling systems to dissipate the heat produced from high-performance computing technologies.

### SUMMARY

A cooling system is disclosed, in accordance with one or more illustrative examples of the present disclosure. In one illustrative example, the cooling system includes a rack system. In another illustrative example, the cooling system includes a plurality of heat exchangers vertically arranged beneath the rack system, where a primary heat exchanger of the plurality of heat exchangers is disposed adjacent to a front portion of the rack system, and a secondary heat exchanger of the plurality of heat exchangers is disposed adjacent to a rear portion of the rack system. In another illustrative example, the cooling system includes a liquid distribution sub-system. In another illustrative example, the liquid distribution sub-system includes one or more supply pipes disposed between the primary and secondary heat exchangers and configured to deliver a cooling fluid to the plurality of heat exchangers, where the cooling fluid is warmed by the plurality of heat exchangers. In another illustrative example, the liquid distribution sub-system includes one or more return pipes configured to collect the warmed cooling fluid from the plurality of heat exchangers. In another illustrative example, the liquid distribution sub-system includes a manifold coupled to at least one of the one or more supply pipes and the one or more return pipes, where the manifold is configured to distribute the cooling fluid throughout the rack system.

A cooling system is disclosed, in accordance with one or more illustrative examples of the present disclosure. In one illustrative example, the cooling system includes a rack system. In another illustrative example, the cooling system includes a plurality of heat exchangers vertically arranged beneath the rack system, where a primary heat exchanger of the plurality of heat exchangers is disposed adjacent to a front portion of the rack system, and a secondary heat exchanger of the plurality of heat exchangers is disposed adjacent to a rear portion of the rack system. In another illustrative example, the cooling system includes a liquid distribution sub-system. In another illustrative example, the liquid distribution sub-system includes one or more supply pipes disposed between the primary and secondary heat exchangers and configured to deliver a cooling fluid to the plurality of heat exchangers, where the cooling fluid is warmed by the plurality of heat exchangers. In another illustrative example, the liquid distribution sub-system includes one or more return pipes configured to collect the warmed cooling fluid from the plurality of heat exchangers. In another illustrative example, the liquid distribution sub-system includes a manifold coupled to at least one of the one or more supply pipes and the one or more return pipes, where the manifold is configured to distribute the cooling fluid throughout the rack system. In another illustrative example, the liquid distribution sub-system includes one or more liquid pumps disposed within the rack system, the one or more liquid pumps configured to communicate with the plurality of heat exchangers.

It is to be understood that both the foregoing general description and the following detailed description are exemplary and explanatory only and are not necessarily restrictive of the invention as claimed. The accompanying drawings, which are incorporated in and constitute a part of the specification, illustrate examples of the invention and together with the general description, serve to explain the principles of the invention.

### BRIEF DESCRIPTION OF THE DRAWINGS

The numerous advantages of the disclosure may be better understood by those skilled in the art by reference to the accompanying figures in which:
FIG. 1 illustrates a front view of a cooling system integrated beneath a rack system within a data center, in accordance with one or more examples of the present disclosure;
FIG. 2 illustrates a front view of the cooling system integrated beneath one of the racks of the rack system, in accordance with one or more examples of the present disclosure;
FIG. 3 illustrates a perspective view of a liquid distribution sub-system positioned beneath one or more racks, in accordance with one or more examples of the present disclosure;
FIG. 4 illustrates a perspective view of an arrangement of a plurality of heat exchangers of the cooling system, in accordance with one or more examples of the present disclosure;
FIG. 5 illustrates a schematic view of a primary heat exchanger and a secondary heat exchanger connected in parallel, in accordance with one example of the present disclosure; and
FIG. 6 illustrates a conceptual view of a primary heat exchanger and a secondary heat exchanger connected in series, in accordance with another example of the present disclosure.

### DETAILED DESCRIPTION

The present disclosure has been particularly shown and described with respect to certain examples and specific features thereof. The examples set forth herein are taken to be illustrative rather than limiting. It should be readily apparent to those of ordinary skill in the art that various changes and modifications in form and detail may be made without departing from the scope of the disclosure.

Reference will now be made in detail to the subject matter disclosed, which is illustrated in the accompanying drawings.

In general, high-power density computer systems, e.g., high-performance computing (HPC), artificial intelligence (Al), and machine learning (ML), are becoming more and more prevalent, driven by advancements in fields like artificial intelligence and machine learning. These high-performance computing systems, while providing exceptional computational capabilities, generate a substantial amount of heat during operation. As a result, effective cooling solutions are needed to ensure the sustained performance, longevity, and reliability of such systems.

Current cooling solutions for HPC racks often rely on an approach that incorporates separate cooling systems for both liquid and air-based methods. This divided arrangement not only introduces unwarranted complexity but also significantly prolongs the installation process. Moreover, the array of air-cooling equipment utilized in these configurations leads to a wasteful allocation of valuable data center space.

Accordingly, examples of the present disclosure are directed to a cooling system that seamlessly integrates air-cooling and liquid-cooling technologies, specifically designed for high-density computer racks. The integrated cooling system may efficiently utilize the space within a raised floor, traditionally reserved for liquid cooling pipe routing, to house the comprehensive cooling assembly. The cooling system may feature a combination of supply and return pipes for both liquid and air cooling, an active liquid-to-air heat exchanger with integrated fans, and an optional passive liquid-to-air heat exchanger. The entire assembly may be preassembled and installed under computer racks, facilitating rapid deployment and significantly reducing the overall build time of data centers. By incorporating both cooling methods within the same infrastructure, this solution maximizes cooling efficiency and simplifies data center maintenance and expansion.

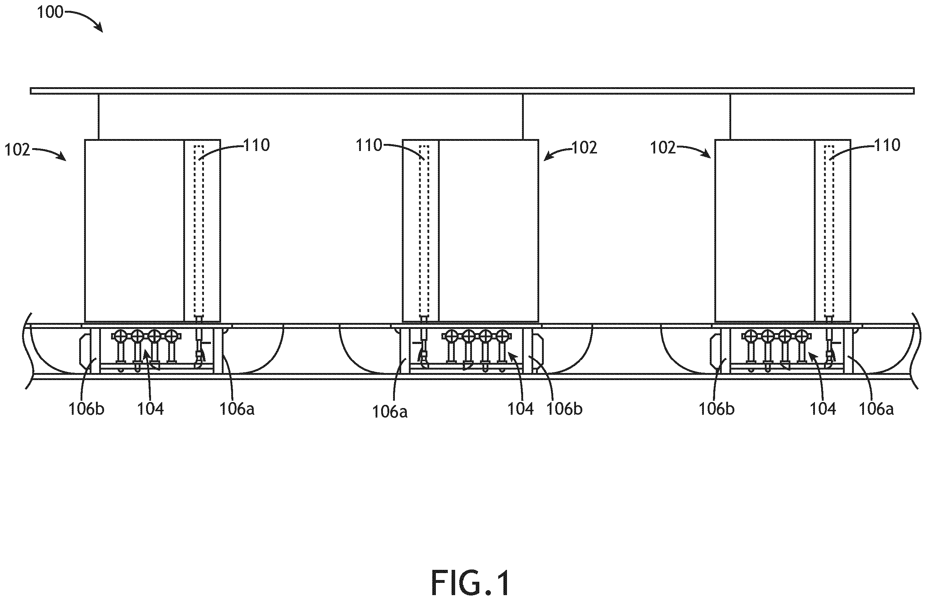

FIGS. 1-6 illustrate a cooling system in accordance with one or more examples of the present disclosure.

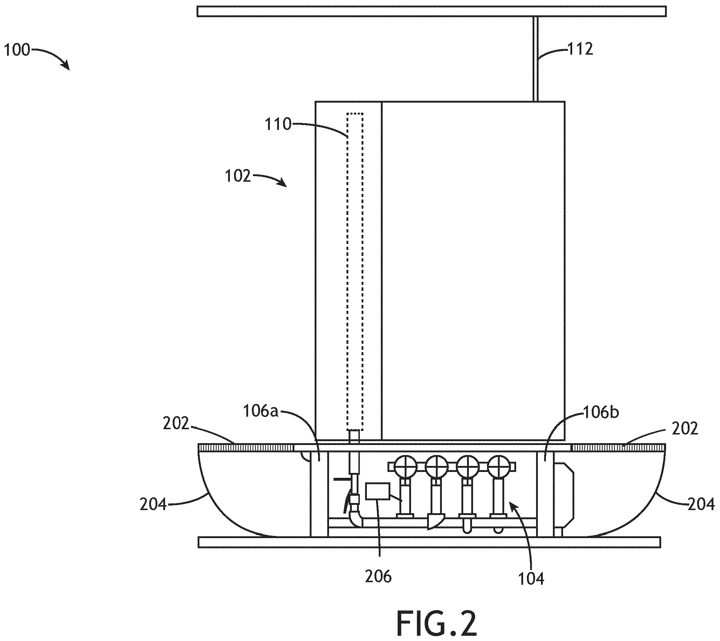

FIGS. 1 and 2 illustrate a front view of a cooling system 100 integrated beneath a rack system 102 within a data center, in accordance with one or more examples of the present disclosure.

In some examples, the cooling system 100 includes at least one of a rack system 102, a liquid distribution sub-system 104, and a plurality of heat exchangers 106 (e.g., a primary heat exchanger 106a and a secondary heat exchanger 106b) disposed beneath the rack system 102. For example, a rack system 102 may serve as the backbone of the cooling system 100, facilitating seamless transport, manipulation, and installation of the liquid distribution sub-system 104 and the plurality of heat exchangers 106 into the rack system 102. By way of another example, the rack system 102 may include a support structure.

In some examples, the cooling system 100 includes one or more liquid pumps 206 (e.g., FIG. 2) integrated within the support structure. For instance, these liquid pumps 206 may be configured to supply liquid to manifolds 110 within individual racks of the rack system 102, enhancing the overall efficiency and reducing the need for additional external pumping infrastructure of the system 100. It is noted herein that this integration may help to simplify the installation process and minimize the required space for additional cooling equipment.

In some examples, the rack system 102 may be configured to accommodate a plurality of other equipment such as, but not limited to, one or more liquid pumps 206, one or more liquid pumps 206 integrated with the plurality of heat exchangers 106, and/or one or more auxiliary racks. For instance, the one or more liquid pumps 206 may be integrated within the support structure. The liquid pumps 206 may be configured to supply liquid to the manifolds 110 within the individual racks of the rack system 102, enhancing the overall efficiency and reducing the need for additional external pumping infrastructure of the system 100. It is noted herein that this integration may help to simplify the installation process and minimize the required space for additional cooling equipment.

Referring to FIG. 2, in some examples, the rack system 102 may include a frame, and may be formed of rigid materials including at least one of metal, plastic, or composite. In addition, one or more raised floor portions or tiles may be integrated between adjacent rows of racks within the rack system 102, enhancing the efficiency of the system. Further, one or more air grilles 202 may be positioned immediately in front of and behind individual racks of the rack system 102 to enhance airflow and cooling performance. It is also noted that one or more air deflectors 204 may be installed on the rack system 102 in response to a need for directed air flow.

In some examples, the cooling system 100 includes various configurations of heat exchangers 106 to suit specific cooling requirements. For example, the system 100 may include configurations such as passive-passive, active-passive, and active-active heat exchangers 106. The primary heat exchanger 106a, which may be passive, may include only heat exchanger coils. This flexibility allows the system 100 to adapt to varying heat loads, providing optimal cooling performance based on the specific needs of the data center 101.

In some examples, the system 100 may include a blanking panel 112 to further enhance cooling efficiency and airflow management. For example, the blanking panel 112 may be positioned between a top surface of each rack within the rack system 102 and the ceiling. This configuration may allow for the creation of distinct cold and hot aisles, allowing for a more precise thermal control. By way of another example, the one or more rows of racks within the rack system 102 may be arranged such that the cold or hot aisles may exist between two rows of the rack system 102 and/or between one row of the rack system 102 and a wall surface.

It is noted herein that within the context of the cooling system 100, the term "hot aisle" and "cold aisle" may refer to distinct temperature-controlled zones within the data center which help manage airflow and cooling efficiency. For example, the "cold aisle" may be defined as the area where the temperature is maintained at a lower range to supply cooled air to the front of the rack system 102. The cold aisle temperature may be maintained at a temperature below, e.g., 25 degrees Celsius, with an ideal operating range between 18 degrees Celsius and, e.g., 22 degrees Celsius. These are merely examples so that the temperature may vary. Alternatively, the cold aisle may be slightly colder than the hot aisle.

Conversely, the "hot aisle" may refer to the area where the temperature is higher due to the expulsion of warm air from the rear portion of the rack system 102. For instance, the hot aisle temperature may range between, e.g., 30 degrees Celsius and, e.g., 45 degrees Celsius, depending on the specific cooling needs and the configuration of the data center. These temperature ranges for the hot and cold aisles are exemplary and may vary based on specific environmental conditions, equipment requirements, and data center design. The cooling system 100 is designed to accommodate these temperature ranges, ensuring reliable and efficient operation of the equipment housed within the rack system 102.

In scenarios where additional heat transfer capacity is unnecessary, the passive heat exchanger may be omitted. This omission may further simplify the system 100 and reduce installation time and costs, without compromising the overall cooling efficiency for certain applications.

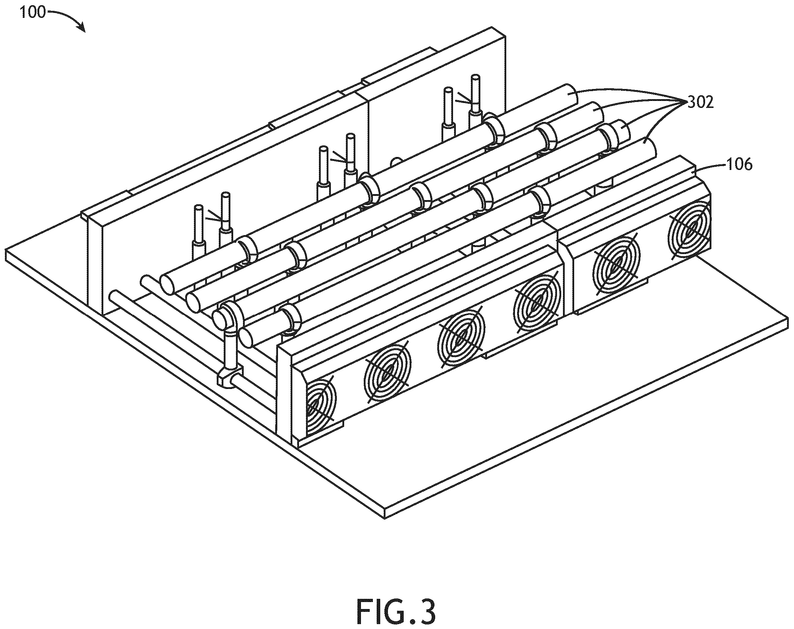

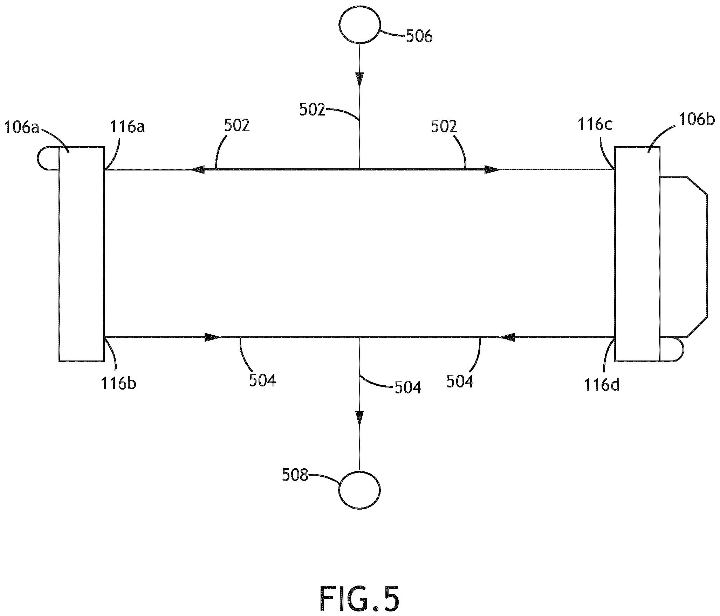

Referring now to FIG. 3, the cooling system 100 may include a liquid distribution sub-system 104 which may include one or more liquid distribution manifolds 110. For example, at least one of the one or more manifolds 110 may be configured to supply the plurality of heat exchangers 106 directly, while at least another manifold of the one or more manifolds 110 may be configured to supply to the manifolds 110 within individual racks of the rack system 102. Each underfloor manifold 110 may be designed to include one or more pipes 302 (e.g., supply pipes 502 and return pipes 504, as shown in FIG. 5) equipped with the necessary framework to regulate at least one of liquid flow, pressure, or temperature.

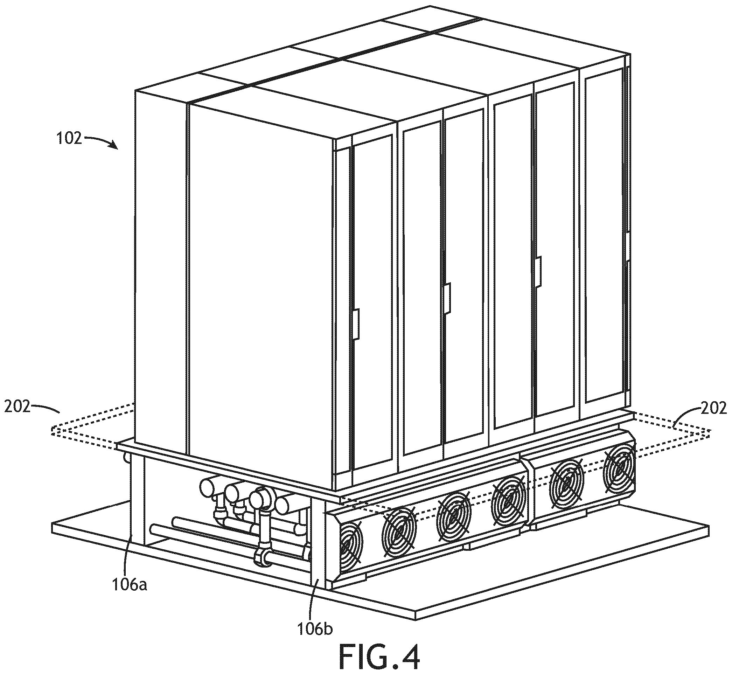

FIG. 4 illustrates the arrangement of the plurality of heat exchangers 106 within the system 100. Each row of the rack system 102 is equipped with a plurality of heat exchangers 106 positioned both underneath a front portion and rear portion of each rack within the rack system 102. The plurality of heat exchangers 106 are configured to offer a high degree of versatility. For example, the plurality of heat exchangers 106 may include at least one primary heat exchanger 106a and at least one secondary heat exchanger 106b, which can be employed based on specific cooling requirements. In some examples, the at least one primary heat exchanger 106a may be configured as an active system, featuring a heat exchanger coil coupled with fans. In other examples, the secondary heat exchanger 106b may be configured as a passive counterpart, comprised solely of a heat exchanger coil. For example, the passive heat exchanger 106 may be omitted when additional heat transfer capacity is unnecessary. It is noted herein that various combinations of primary and secondary heat exchangers 106 are feasible, offering adaptability to varying heat loads. Combinations may include, but are not limited to, passive-passive, active-passive, and/or configurations featuring one active and one passive heat exchanger.

It is noted herein that the plurality of heat exchangers 106 and corresponding distribution may include, but are not limited to, any specific cooling technology such as chilled water systems and/or direction expansion through a refrigerant pipeline.

In some examples, the system 100 may be designed to optimize airflow and thermal management. For example, cold air (e.g., below 25 degrees Celsius) may be directed towards the front of individual racks within the rack system 102 through one or more air grilles 202 in the raised floor portions, while hot air (e.g., between 30 degrees Celsius and 45 degrees Cesius) is efficiently extracted from the rear portion of individual racks within the rack system 102 through one or more additional grilles 202. It is noted herein that the presence of the raised floor is not mandatory, and the system 100 remains fully functional even without it.

It is further noted herein that the raised floor portions, while not mandatory, may significantly enhance the efficiency of the cooling system 100. For instance, the raised floor may allow for effective routing of both liquid and air-cooling pipes, and the integration of air grilles 202 to ensure optimal airflow management. Cold air may be directed towards the front of individual racks within the rack system 102 through the air grilles 202, while hot air is extracted from the rear, ensuring a consistent and efficient cooling cycle. In some configurations, air deflectors 204 may be installed to direct airflow more precisely, based on the layout of the data center 101.

FIG. 5 showcases a configuration, of the system 100, employing a plurality of heat exchangers 106 that are connected to the liquid distribution manifold 110 in a parallel arrangement.

In examples, the one or more supply and return pipes 502 and 504 of the cooling system 100 play a critical role in managing the distribution and return, respectively, of cooling fluids within the high-density computer racks. For instance, the one or more supply pipes 502 may be configured to deliver the cooling fluid to various components of the cooling system 100 including, but not limited to, the plurality of heat exchangers 106 and the manifolds 110. Further, the one or more supply pipes 502 may be configured to fluidically couple the manifold 110 to the primary heat exchanger 106a and the secondary heat exchanger 106b simultaneously. As a result, the cooling fluid may be distributed evenly to the inlets 116a and 116c of the primary heat exchanger 106a and the secondary heat exchanger 106b, respectively. After passing through each heat exchanger, the warmed cooling fluid may exit through outlets 116b and 116d and return to the manifold 110 via the one or more return pipes 504.

In examples, in the parallel configuration, the one or more supply pipes 502 may be bent at an angle of approximately 90 degrees to facilitate even distribution of the cooling fluid across both the primary heat exchanger 106a and the secondary heat exchanger 106b. This configuration may allow for each heat exchanger 106a, 106b to operate independently, enabling selective engagement based on the cooling demands of the rack system 102. The one or more pipes 502, 504 may also support combinations of active and passive heat exchangers, depending on the specific cooling needs.

It is noted herein that one or more monitoring devices 506 may also be installed along the one or more supply pipes 502 to ensure that the flow rate, temperature, and pressure are maintained at optimal levels. For example, the one or more monitoring devices 506 may include one or more flow control valves positioned along the one or more supply pipes 502, which help to regulate the flow rate of the cooling fluid. The one or more monitoring devices 506 may further include one or more pressure regulators used to maintain consistent pressure within the one or more supply pipes 502, preventing potential damage from pressure fluctuations. The one or more monitoring devices 506 may further include one or more temperature sensors used to monitor the temperature of the cooling fluid as it travels through the one or more supply pipes 502, providing real-time data to a control system for optimal thermal management.

It is further noted herein that the one or more return pipes 504 may include one or more monitoring devices 508 configured to regulate at least one of a liquid flow, pressure, or temperature. The one or more monitoring devices 508 may include one or more flow meters used to measure the rate of fluid return, providing data to help balance the system 100. The one or more monitoring devices 508 may further include one or more check valves used to prevent backflow, ensuring that the cooling fluid moves in the correct direction through the one or more return pipes 504. The one or more monitoring devices 508 may further include one or more temperature and pressure sensors used to continuously monitor conditions within the one or more return pipes 504, ensuring that the system 100 operates within safe and efficient parameters.

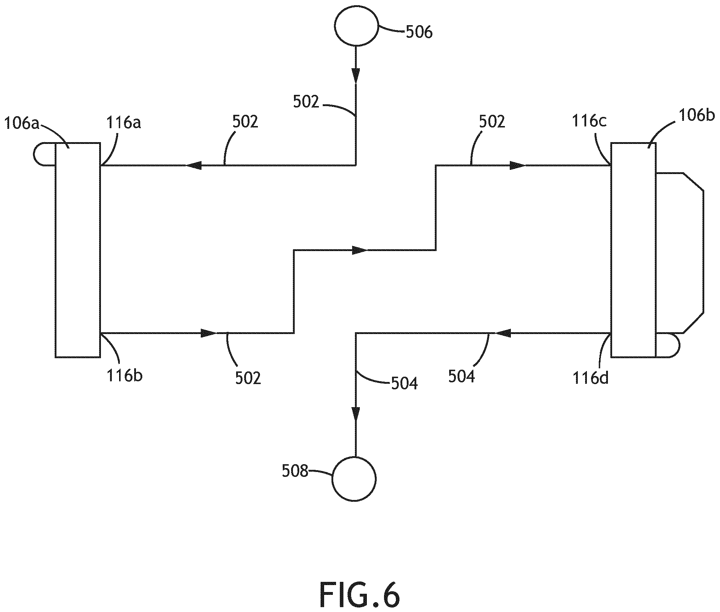

On the other hand, FIG. 6 showcases a configuration, of the system 100, employing a plurality of heat exchangers 106 that are connected to the liquid distribution manifold 110 in a series arrangement. The connection type may be determined by the specific operational conditions faced in the system 100.

In examples, the one or more supply pipes 502 are configured to fluidically couple the manifold 110 to the primary heat exchanger 106a via an inlet 116a. After passing through the primary heat exchanger 106a, the warmed cooling fluid may exit through an outlet 116b of the primary heat exchanger 106a. The warmed fluid is then directed through the one or more supply pipes 502, designated as either line 502 or line 504, depending on the specific configuration, which is connected between the outlet 116b of the primary heat exchanger 106a and an inlet 116c of the secondary heat exchanger 106b. The cooling fluid then enters the secondary heat exchanger 106b, where it undergoes additional cooling. Finally, the cooled fluid exits the secondary heat exchanger 106b through an outlet 116d of the secondary heat exchanger 106b and is returned to the manifold 110 via the one or more return pipes 504.

In examples, the one or more supply pipes 502 and the one or more return pipes 504 are strategically bent at an angle ranging between 45 and 90 degrees, which is dependent upon the spatial constraints and specific configuration of the rack system 102. For instance, the bending of the one or more supply pipes 502 and the one or more return pipes 504 ensures smooth fluid flow and efficient use of space, minimizing turbulence and maintaining consistent flow rates. Further, a monitoring device 506 may be installed along the one or more supply pipes 502 and the one or more return pipes 504 to regulate the temperature and pressure of the cooling fluid as it flows to and from the primary heat exchanger 106a and the secondary heat exchanger 106b.

It is noted herein that the series configuration may maximize the heat transfer efficiency by allowing the cooling fluid to progressively cool as it flows through both heat exchangers 106. The series arrangement is ideal for situations where a higher degree of cooling is required, or where the cooling load is uneven and needs to be managed sequentially. The angles and bends in the one or more supply and return pipes 502 and 504, respectively, are calculated to minimize turbulence and maintain steady flow rates, which is critical for ensuring consistent cooling performance.

It should be noted that while the parallel and series configurations shown in FIGS. 5 and 6 are exemplary examples, the invention is not limited to these specific arrangements. Other possible configurations may be implemented depending on the particular cooling requirements and spatial constraints of the data center. For example, variations in the angles of the bends in the one or more supply and return pipes 502 and 504, respectively, the use of additional monitoring device 506, or the integration of supplemental cooling components may be employed to optimize the cooling system 100 performance in various scenarios.

In examples, the cooling system 100 presents a unique approach by combining cooling equipment and infrastructure, primarily the liquid coolant pipes, within a single unified assembly. This design helps to streamline manufacturing and installation, significantly reducing both time and space requirements. In comparison to traditional cooling systems, it drastically cuts down installation time, resulting in reduced data center build times and enhanced space utilization. This ultimately translates to more available space for individual computer racks of the rack system 102 or the possibility of downsizing data center facilities while maintaining optimal cooling performance.

One skilled in the art will recognize that the herein described components (e.g., operations), devices, objects, and the discussion accompanying them are used as examples for the sake of conceptual clarity and that various configuration modifications are contemplated. Consequently, as used herein, the specific exemplars set forth and the accompanying discussion are intended to be representative of their more general classes. In general, use of any specific exemplar is intended to be representative of its class, and the non-inclusion of specific components (e.g., operations), devices, and objects should not be taken as limiting.

The previous description is presented to enable one of ordinary skill in the art to make and use the invention as provided in the context of a particular application and its requirements. As used herein, directional terms such as "top," "bottom," "over," "under," "upper," "upward," "lower," "down," and "downward" are intended to provide relative positions for purposes of description, and are not intended to designate an absolute frame of reference. Various modifications to the described examples will be apparent to those with skill in the art, and the general principles defined herein may be applied to other examples. Therefore, the present invention is not intended to be limited to the particular examples shown and described, but is to be accorded the widest scope consistent with the principles and novel features herein disclosed.

With respect to the use of substantially any plural and/or singular terms herein, those having skill in the art can translate from the plural to the singular and/or from the singular to the plural as is appropriate to the context and/or application. The various singular/plural permutations are not expressly set forth herein for sake of clarity.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected," or "coupled," to each other to achieve the desired functionality, and any two components capable of being so associated can also be viewed as being "couplable," to each other to achieve the desired functionality. Specific examples of couplable include but are not limited to physically mateable and/or physically interacting components and/or wirelessly interactable and/or wirelessly interacting components and/or logically interacting and/or logically interactable components.

Furthermore, it is to be understood that the invention is defined by the appended claims. It will be understood by those within the art that, in general, terms used herein, and especially in the appended claims (e.g., bodies of the appended claims) are generally intended as "open" terms (e.g., the term "including" should be interpreted as "including but not limited to," the term "having" should be interpreted as "having at least," the term "includes" should be interpreted as "includes but is not limited to," and the like). It will be further understood by those within the art that if a specific number of an introduced claim recitation is intended, such an intent will be explicitly recited in the claim, and in the absence of such recitation no such intent is present. For example, as an aid to understanding, the following appended claims may contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to inventions containing only one such recitation, even when the same claim includes the introductory phrases "one or more" or "at least one" and indefinite articles such as "a" or "an" (e.g., "a" and/or "an" should typically be interpreted to mean "at least one" or "one or more"); the same holds true for the use of definite articles used to introduce claim recitations. In addition, even if a specific number of an introduced claim recitation is explicitly recited, those skilled in the art will recognize that such recitation should typically be interpreted to mean at least the recited number (e.g., the bare recitation of "two recitations," without other modifiers, typically means at least two recitations, or two or more recitations). Furthermore, in those instances where a convention analogous to "at least one of A, B, and C, and the like" is used, in general such a construction is intended in the sense one having skill in the art would understand the convention (e.g., " a system having at least one of A, B, and C" would include but not be limited to systems that have A alone, B alone, C alone, A and B together, A and C together, B and C together, and/or A, B, and C together, and the like). In those instances where a convention analogous to "at least one of A, B, or C, and the like" is used, in general such a construction is intended in the sense one having skill in the art would understand the convention (e.g., " a system having at least one of A, B, or C" would include but not be limited to systems that have A alone, B alone, C alone, A and B together, A and C together, B and C together, and/or A, B, and C together, and the like). It will be further understood by those within the art that virtually any disjunctive word and/or phrase presenting two or more alternative terms, whether in the description, claims, or drawings, should be understood to contemplate the possibilities of including one of the terms, either of the terms, or both terms. For example, the phrase "A or B" will be understood to include the possibilities of "A" or "B" or "A and B."

Further examples are set out in the clauses below:
1. A cooling system, comprising: a rack system;
   a plurality of heat exchangers vertically arranged beneath the rack system, wherein a primary heat exchanger of the plurality of heat exchangers is disposed adjacent to a front portion of the rack system, and a secondary heat exchanger of the plurality of heat exchangers is disposed adjacent to a rear portion of the rack system; and
   a liquid distribution sub-system, comprising:
      one or more supply pipes disposed between the primary and secondary heat exchangers and configured to deliver a cooling fluid to the plurality of heat exchangers, wherein the cooling fluid is warmed by the plurality of heat exchangers;
      one or more return pipes configured to collect the warmed cooling fluid from the plurality of heat exchangers; and
      a manifold coupled to at least one of the one or more supply pipes and the one or more return pipes, wherein the manifold is configured to distribute the cooling fluid throughout the rack system.
2. The cooling system of Clause 1, wherein the one or more supply pipes and the one or more return pipes are arranged transversally and longitudinally relative to the rack system to provide support for vertical arrangement of the plurality of heat exchangers.
3. The cooling system of any one of the preceding Clauses, wherein the rack system includes a raised floor portion configured to direct cold air to the front portion of the rack system and hot air from the rear portion of the rack system through one or more air grilles in the raised floor portion.
4. The cooling system of Clause 3, wherein the one or more air grilles are disposed on opposing sides of the rack system to direct airflow.
5. The cooling system of any one of the preceding Clauses, wherein the primary heat exchanger of the plurality of heat exchangers includes an active heat exchanger comprising one or more fans and a heat exchanger coil.
6. The cooling system of any one of the preceding Clauses, wherein the secondary heat exchanger of the plurality of heat exchangers includes a passive heat exchanger comprising a heat exchanger coil.
7. The cooling system of Clause 5, wherein the one or more fans of the primary heat exchanger are configured to face outward to direct airflow across the heat exchanger coil.
8. The cooling system of any one of the preceding Clauses, further comprising one or more liquid pumps disposed within the rack system, the one or more liquid pumps configured to communicate with the plurality of heat exchangers.
9. The cooling system of Clause 8, wherein the one or more liquid pumps are configured to distribute the cooling fluid to the manifold within the rack system.
10. The cooling system of any one of the preceding Clauses, wherein the rack system further comprises one or more air deflectors configured to direct air flow.
11. A cooling system, comprising:
   a rack system;
   a plurality of heat exchangers vertically arranged beneath the rack system, wherein a primary heat exchanger of the plurality of heat exchangers is disposed adjacent to a front portion of the rack system, and a secondary heat exchanger of the plurality of heat exchangers is disposed adjacent to a rear portion of the rack system; and
   a liquid distribution sub-system, comprising:
      one or more supply pipes disposed between the primary and secondary heat exchangers and configured to deliver a cooling fluid to the plurality of heat exchangers, wherein the cooling fluid is warmed by the plurality of heat exchangers;
      one or more return pipes configured to collect the warmed cooling fluid from the plurality of heat exchangers;
      a manifold coupled to at least one of the one or more supply pipes and the one or more return pipes, wherein the manifold is configured to distribute the cooling fluid throughout the rack system; and
      one or more liquid pumps disposed within the rack system, the one or more liquid pumps configured to communicate with the plurality of heat exchangers.
12. The cooling system of Clause 11, wherein the one or more supply pipes and the one or more return pipes are arranged transversally and longitudinally relative to the rack system to provide support for vertical arrangement of the plurality of heat exchangers.
13. The cooling system of Clause 11 or 12, wherein the rack system includes a raised floor portion configured to direct cold air to the front portion of the rack system and hot air from the rear portion of the rack system through one or more air grilles in the raised floor portion.
14. The cooling system of Clause 13, wherein the one or more air grilles are disposed on opposing sides of the rack system to direct airflow.
15. The cooling system of any one of Clauses 11-14, wherein the primary heat exchanger of the plurality of heat exchangers includes an active heat exchanger comprising one or more fans and a heat exchanger coil.
16. The cooling system of any one of Clauses 11-15, wherein the secondary heat exchanger of the plurality of heat exchangers includes a passive heat exchanger comprising a heat exchanger coil.
17. The cooling system of Clause 15, wherein the one or more fans of the primary heat exchanger are configured to face outward to direct airflow across the heat exchanger coil.
18. The cooling system of any one of Clauses 11-17, wherein the primary and secondary heat exchangers are connected to the manifold in a parallel configuration, such that the cooling fluid is distributed simultaneously to the primary and the secondary heat exchangers.
19. The cooling system of any one of Clauses 11-18, wherein the primary and secondary heat exchangers are connected to the manifold in a series configuration, such that the cooling fluid flows sequentially through the primary heat exchanger and then through the secondary heat exchanger.
20. The cooling system of any one of Clauses 11-19, wherein the one or more supply pipes and the one or more return pipes each communicates with a monitoring system configured to regulate at least one of a liquid flow, pressure, or temperature.

It is believed that the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

2. A cooling system, comprising:
a rack system;
a plurality of heat exchangers vertically arranged beneath the rack system, wherein a primary heat exchanger of the plurality of heat exchangers is disposed adjacent to a front portion of the rack system, and a secondary heat exchanger of the plurality of heat exchangers is disposed adjacent to a rear portion of the rack system; and
a liquid distribution sub-system, comprising:
one or more supply pipes disposed between the primary and secondary heat exchangers and configured to deliver a cooling fluid to the plurality of heat exchangers, wherein the cooling fluid is warmed by the plurality of heat exchangers;
one or more return pipes configured to collect the warmed cooling fluid from the plurality of heat exchangers; and
a manifold coupled to at least one of the one or more supply pipes and the one or more return pipes, wherein the manifold is configured to distribute the cooling fluid throughout the rack system.
2. The cooling system of Claim 1, wherein the one or more supply pipes and the one or more return pipes are arranged transversally and longitudinally relative to the rack system to provide support for vertical arrangement of the plurality of heat exchangers.

3. The cooling system of Claim 1 or 2, wherein the rack system includes a raised floor portion configured to direct cold air to the front portion of the rack system and hot air from the rear portion of the rack system through one or more air grilles in the raised floor portion.

4. The cooling system of Claim 3, wherein the one or more air grilles are disposed on opposing sides of the rack system to direct airflow.

5. The cooling system of any one of Claims 1-4, wherein the primary heat exchanger of the plurality of heat exchangers includes an active heat exchanger comprising one or more fans and a heat exchanger coil.

6. The cooling system of any one of Claims 1-5, wherein the secondary heat exchanger of the plurality of heat exchangers includes a passive heat exchanger comprising a heat exchanger coil.

7. The cooling system of Claim 5, wherein the one or more fans of the primary heat exchanger are configured to face outward to direct airflow across the heat exchanger coil.

8. The cooling system of and one of Claims 1-7, further comprising one or more liquid pumps disposed within the rack system, the one or more liquid pumps configured to communicate with the plurality of heat exchangers.

9. The cooling system of Claim 8, wherein the one or more liquid pumps are configured to distribute the cooling fluid to the manifold within the rack system.

10. The cooling system of any one of Claims 1-9, wherein the rack system further comprises one or more air deflectors configured to direct air flow.

11. The cooling system of any one of the preceding Claims, wherein the primary and secondary heat exchangers are connected to the manifold in a parallel configuration, such that the cooling fluid is distributed simultaneously to the primary and the secondary heat exchangers.

12. The cooling system of any one of the preceding Claims, wherein the primary and secondary heat exchangers are connected to the manifold in a series configuration, such that the cooling fluid flows sequentially through the primary heat exchanger and then through the secondary heat exchanger.

13. The cooling system of any one of the preceding Claims, wherein the one or more supply pipes and the one or more return pipes each communicates with a monitoring system configured to regulate at least one of a liquid flow, pressure, or temperature.
